Europäisches Patentamt

European Patent Office

Office européen des brevets

(11) Veröffentlichungsnummer: **0 483 782 A2**

# EUROPÄISCHE PATENTANMELDUNG

(21) Anmeldenummer: **91118472.9**

(51) Int. Cl.5: **C23C 18/14**

(22) Anmeldetag: **30.10.91**

(30) Priorität: **02.11.90 DE 4034834**

(43) Veröffentlichungstag der Anmeldung:
**06.05.92 Patentblatt 92/19**

(84) Benannte Vertragsstaaten:
**CH DE FR GB LI NL**

(71) Anmelder: **ABB PATENT GmbH**
**Kallstadter Strasse 1**
**W-6800 Mannheim 31(DE)**

(72) Erfinder: **Esrom, Hilmar, Dr.**
**Obere Höhe 6**
**W-6803 Edingen-Neckarhausen(DE)**

(74) Vertreter: **Rupprecht, Klaus, Dipl.-Ing. et al**
**c/o ABB Patent GmbH, Patentabteilung,**
**Postfach 10 03 51**
**W-6800 Mannheim 1(DE)**

(54) Verfahren zur Herstellung metallischer Schichten auf Substraten.

(57) Es wird ein Verfahren zur Herstellung von ganzflächigen oder partiellen metallischen Schichten aus einer metallorganischen Verbindung auf einem Substrat durch Bestrahlung mit einer Lichtquelle vorgeschlagen, bei dem ein mit der metallorganischen Verbindung (2) beschichteter UV- oder lichtdurchlässiger Träger (1) mit vorgegebenem Abstand (A) vor dem Substrat (3) angeordnet wird, wobei die metallorganische Verbindung dem Substrat zugewandt ist. Anschließend wird die metallorganische Verbindung der Einwirkung von gepulsten Photonenstrahlen einer definierten Wellenlänge, vorzugsweise der Wellenlänge 190 nm...550 nm, ausgesetzt. Alternativ wird der Photonenstrahl mit Hilfe einer Linse (5) gebündelt und ist gegenüber dem Träger/Substrat (1/2/3) in XYZ-Richtung verschiebbar oder es befindet sich eine Maske (23,26) vor oder hinter dem Träger (1). Anschließend erfolgt eine Verstärkung der metallischen Schicht durch stromlose oder galvanische Metallisierung.

Fig.1

Die Erfindung bezieht sich auf ein Verfahren zur Herstellung von ganzflächigen oder partiellen metallischen Schichten aus einer metallorganischen Verbindung auf einem Substrat durch Bestrahlung mit einer Lichtquelle.

Aus J. Appl. Phys. 60, 1538 (1986) ist ein Verfahren zur Herstellung von strukturierten Metallschichten auf einem Substrat bekannt. Bei diesem Verfahren werden Metalle von einem durchsichtigen Träger mit Hilfe von gepulster Laserstrahlung auf ein hinter der Metallschicht befindliches Substrat übertragen. Das Verfahren hat erhebliche Nachteile:

- Die zu übertragenden Metalle müssen auf lichtdurchlässige Träger aufgedampft oder aufgesputtert werden, wobei dieser Schritt aufgrund der einzusetzenden Vakuumverfahren sehr kostenintensiv ist.
- In Abhängigkeit von der Metallart und den damit verbundenen physikalischen Eigen-schaften (Reflexion, Absorption, Wärmeleitfä-higkeit etc.) und der Schichtdicke (0.1 $\mu$m -1 $\mu$m) müssen Laserparameter (Pulsenergie, Pulslänge, Wellenlänge) geeignet gewählt werden, was den Prozeß insgesamt kompliziert gestaltet.
- Die erzielbaren Schichtdicken sind begrenzt (<1 $\mu$m).
- Die übertragenen Metallschichten auf dem Substrat haben unregelmäßige Strukturen (schlechte Kantenschärfe und Homogenität).
- Durch die eingebrachte Wärme oxidieren die übertragenen Metalle, so daß in vielen Fällen unter Schutzgas gearbeitet werden muß (teurer Verfahrensschritt).
- Verbliebene Metallreste auf dem Träger sind Verluste oder müßten teuer rückgewonnen werden.

Der Erfindung liegt die Aufgabe zugrunde, ein wirtschaftliches Verfahren zur Herstellung metallischer Schichten auf Substraten anzugeben, bei dem Substrate nicht mit Lösungsmittel belastet werden.

Diese Aufgabe wird in Verbindung mit den Merkmalen des Oberbegriffes des Anspruches 1 dadurch gelöst, daß ein mit der metallorganischen Verbindung beschichteter, UV- oder lichtdurchlässiger Träger mit vorgegebenem Abstand vor dem Substrat angeordnet wird, wobei die metallorganische Verbindung dem Substrat zugewandt ist und daß anschließend die metallorganische Verbindung der Einwirkung von Photonenstrahlen einer definierten Wellenlänge, vorzugsweise der Wellenlänge 190 nm bis 550 nm, ausgesetzt wird.

Dabei wird der metallorganische Film von dem Träger abgelöst und auf dem Wege zum Substrat werden die metallorganischen Moleküle thermisch zersetzt, so daß ein dünner Film aus den entsprechenden Metallen auf dem Substrat gebildet wird.

Die mit der Erfindung erzielbaren Vorteile bestehen insbesondere darin, daß das Verfahren auch zur Beschichtung von Substraten eingesetzt werden kann, die von üblichen Lösungsmitteln, z.B. Chloroform, angegriffen werden, da das Substrat lediglich mit der gewünschten Metallschicht versehen ist und keine nicht zersetzten Filmanteile unter Verwendung von Lösungsmitteln vom Substrat entfernt werden müssen, d.h. Lösungsmittel kommen mit dem zu beschichtenden Substrat nicht in Berührung. Das ist für eine Reihe von Kunststoffen von Vorteil sowie umweltfreundlich und im Produktionsbereich erwünscht. Die Umweltfreundlichkeit begründet sich zusätzlich auf der Möglichkeit, die nicht in Metallschichten umgewandelten Teilflächen der metallorganischen Verbindung durch Recycling, d.h. Ablösung in dem entsprechenden Lösungsmittel, einer Wiederverwendung zuzuführen, was eine Materialersparnis bewirkt und zusätzlich zur Wirtschaftlichkeit des Verfahrens beiträgt. Ein weiterer wichtiger Vorteil liegt in der einfachen Präparation der Träger. Die metallorganischen Verbindungen werden mit Hilfe von Lösungsmitteln durch Tauchen, Sprühen und Aufschleudern bei Raumtemperatur an Luft auf die Träger aufgebracht.

Einen weiteren Vorteil stellen die niedrigen Prozeßtemperaturen unter 100°C dar, die im wesentlichen durch die stromlosen chemischen Bäder oder direkten galvanischen Verfahren, die zur Verstärkung der bekeimten Oberflächen dienen, bestimmt werden. Hierdurch lassen sich auch temperaturempfindliche Substrate, wie z.B. bestimmte Kunststoffe, problemlos mit einer Vielzahl von Metallen, wie Cu, Ni, Au, Pt etc., beschichten.

Besondere Vorteile weist das vorgeschlagene Verfahren auf, wenn Substrate mit erhabener Struktur, beispielsweise Leiterplatten mit erhabenen Leiterbahnen, metallisiert werden sollen. Dies kann in sehr einfacher Weise erfolgen, ohne daß besondere Verfahrensschritte aufgrund der erhabenen Struktur erforderlich sind.

Mit dem vorgeschlagenen Verfahren können Strukturen mit guter Kantenschärfe hergestellt werden.

Da sich die physikalischen Eigenschaften der verschiedenen metallorganischen Verbindungen nur unwesentlich unterscheiden, sind die Prozeßparameter übertragbar (Prozeßflexibilität).

Vorteilhafte Ausgestaltungen des Verfahrens sind in den Unteransprüchen gekennzeichnet.

Die Erfindung wird nachstehend anhand der in der Zeichnung dargestellten Ausführungsbeispiele erläutert.

Es zeigen:

Fig. 1          die prinzipielle Wirkungsweise des Verfahrens zur Herstellung metallischer Schichten auf Substraten,

Fig. 2,3          Substrate mit erhabener Struktur,

Fig. 4          eine erste Variante des Verfahrens mit einer Maske vor der metallorganischen Verbindung,

Fig. 5          eine zweite Variante des Verfahrens mit einer Maske vor dem Substrat,

Fig. 6          eine dritte Variante des Verfahrens, bei der der Photonenstrahl gegenüber der metallorganischen Verbindung bzw. dem Substrat in XY-Richtung verschiebbar ist.

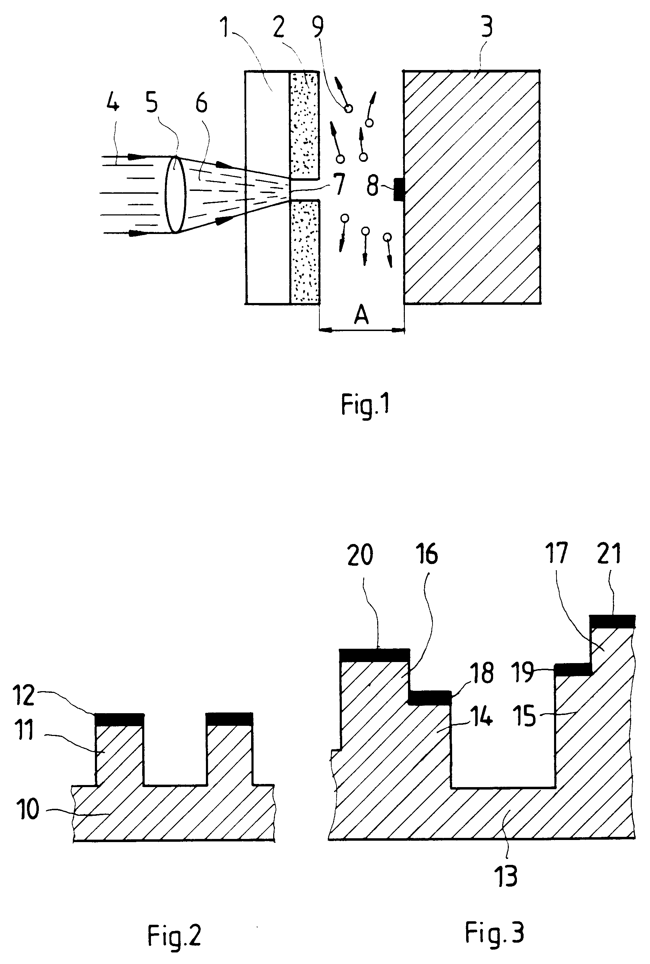

In Fig. 1 ist die prinzipielle Wirkungsweise des Verfahrens zur Herstellung metallischer Schichten auf Substraten dargestellt. Es ist ein UV- oder sichtbares Lichtdurchlässiger Träger 1 zu erkennen, der vor einen Substrat 3 angeordnet ist und auf seiner dem Substrat zugewandten Frontseite 7 mit einem metallorganischem Film 2 beschichtet ist. Die unbeschichtete Oberfläche des Trägers 1 wird von einem Excimerlaserstrahl 4 beaufschlagt, wobei zur Bündelung des Excimerlaserstrahls 4 eine Linse 5 vorgesehen werden kann. Der gebündelte Excimerlaserstrahl 6 bewirkt eine Zersetzung des metallorganischen Films 2. Bei der Zersetzung dieses Filmes wird die metallorganische Verbindung dissoziiert, wobei die flüchtigen Liganden 9 abgespalten werden. Aufgrund des Laserpulses haben die freigesetzten (deponierten) Metallatome einen Impuls in Richtung des Substrats und bilden eine metallische Schicht 8 auf der Substratoberfläche. Der Abstand A zwischen dem metallorganischem Film 2 und der Substratoberfläche beträgt je nach Anwendungsfall einige um bis einige Millimeter.

Die deponierten Metallschichten auf den Substrat werden in stromlosen, naßchemischen oder galvanischen Bädern verstärkt.

In den Fig. 2 und 3 sind Substrate mit erhabener Struktur dargestellt, wobei vorzugsweise die Dachflächen der erhabenen Strukturen selbst metallisch zu beschichten sind. In Fig. 2 ist eine Leiterplatte 10 als Substrat zu erkennen, deren erhabene Stege 11 mit Metallisierungen 12 gemäß dem unter Fig. 1 prinzipiell beschriebenen Verfahren versehen sind. Durch die erhabenen Stege 11 werden vorteilhaft mittels der Metallisierungen 12 Leiterbahnen mit verlängerten Kriechwegabständen gebildet, d.h. benachbarte Leiterbahnen können mit höherer Potentialdifferenz beaufschlagt werden als dies der lichten Weite zwischen den Leiterbahnen entspricht.

In Fig. 3 ist eine Leiterplatte 13 als Substrat zu erkennen, die verschiedene erhabene Stege unterschiedlicher Höhe aufweist. Zwei erhabene Stege 14,15 haben ihre Basis direkt auf der Substratoberfläche, während sich ein weiterer, den Steg 14 überragender Steg 16 direkt an den Steg 14 und ein weiterer, den Steg 15 überragender Steg 17 direkt an den Steg 15 anschließt. Die Dachflächen der Stege 14 bis 17 sind jeweils mit Metallisierungen 18 bis 21 gemäß dem unter Fig.1 prinzipiell beschriebenen Verfahren versehen. Durch die Metallisierungen 18,19 werden separierte Leiterbahnen gebildet, obwohl die Metallisierungen selbst nicht getrennt, sondern gemeinsan und ohne räumlichen Abstand produziert werden. Die räumliche Trennung ergibt sich erst durch die unterschiedlichen Höhen der Dachflächen der Stege 14,16. Das gleiche gilt auch für die Stege 15, 17 und deren Metallisierungen 19,21. Diese selektive Metallisierung wird vorteilhaft ohne jeden Ätzschritt realisiert.

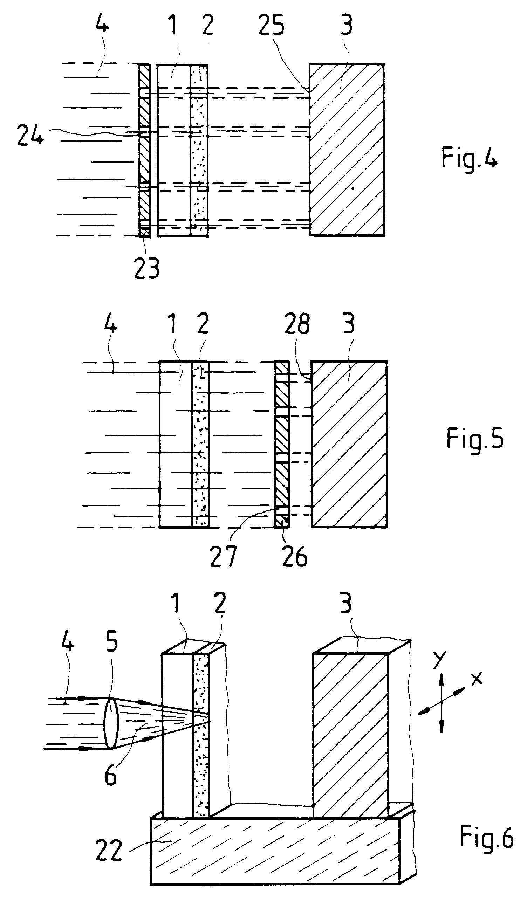

In Fig. 4 ist eine erste Variante des Verfahrens unter Einsatz einer Maske vor der metallorganischen Verbindung dargestellt. Es sind wiederum der mit einem metallorganischen Film 2 beschichtete Träger 1 und das Substrat 3 zu erkennen, wobei eine Maske 23 zwischen dem Excimerlaserstrahl und dem Träger 1 angeordnet ist. Eine Bündelung des Laserstrahls durch eine Linse - wie in Fig. 1 angedeutet - ist bei diesem Projektionsverfahren nicht notwendig, aber auch nicht ausgeschlossen. Der Excimerlaserstrahl 4 durchdringt die Maske 23 lediglich am Ort ihrer Durchbrüche 24 und löst an den bestrahlten Stellen des metallorganischen Films 2 die unter Fig. 1 erwähnten Zersetzungsprozesse aus, wodurch an den Projektionsflächen 25 auf der Substratoberfläche die gewünschten Metallisierungen mit der Breite und der Länge der Durchbrüche 24 produziert werden.

Die Bestrahlung der Pulverschicht 2 oder eines getrockneten Lösungsfilms durch die Durchlässe 24 hindurch wird einige 100 ns durchgeführt. Die typische Pulsbreite beträgt 10-30 ns. Die Anzahl der Pulse wird von den jeweiligen Gegebenheiten bestimmt. Die Pulverschichten 2, welche durch die Maske vor einer Bestrahlung abgeschirmt wurden, können anschließend mit Hilfe eines Gasstrahles von der Oberfläche des Trägers 1 entfernt werden. Die nicht bestrahlten Reste des Lösungsfilms werden abgewaschen.

In Fig. 5 ist eine zweite Variante des Verfahrens unter Einsatz einer Maske vor dem Substrat dargestellt. Es sind wiederum der mit einem metallorganischen Film 2 beschichtete Träger 1 und das Substrat 3 zu erkennen, wobei eine Maske 26 zwischen dem metallorganischen Film 2 und dem Substrat 3 angeordnet ist. Eine Bündelung des Laserstrahls durch eine Linse - wie in Fig. 1 angedeutet - ist bei diesem Projektionsverfahren nicht notwendig, jedoch auch nicht ausgeschlossen. Der Excimerlaserstrahl 4 durchdringt den Träger 1 ganzflächig und löst die unter Fig. 1 erwähnten Zersetzungsprozesse am metallorganischen Film 2 ganzflächig aus. Die deponierten Metallatome durchdringen die Maske 26 jedoch lediglich am Ort ihrer Durchbrüche 27, wodurch an den Projektionsflächen 28 auf der Substratoberfläche die gewünschten Metallisierungen produziert werden. Die die Maske 26 nicht durchdringenden deponierten Metallatome schlagen sich auf der Oberfläche der Maske 26 selbst nieder. Die Maske 26 kann sich auch direkt auf dem Film 2 befinden.

Für beide Projektionsverfahren gemäß Figuren 4 und 5 gilt, daß entweder ganzflächig bestrahlt oder mit den Strichfokus abgescannt wird. Die Maskenverfahren gemäß Fig. 4, 5 sind insbesondere dann vorteilhaft, wenn simultan feine Strukturen und großflächige Metallisierungen auf Substratoberflächen gefordert werden. Insbesondere können auch zweidimensionale Strukturen beschichtet werden (siehe hierzu Fig. 2, 3).

In Fig. 6 ist eine dritte Variante des Verfahrens dargestellt, bei der der Photonenstrahl gegenüber der metallorganischen Verbindung bzw. dem Substrat in XYZ-Richtung verschiebbar ist. Es sind wiederum der mit einem metallorganischen Film 2 beschichtete Träger 1 und das Substrat 3 zu erkennen, wobei sowohl Träger 1 als auch Substrat 3 auf einem XYZ-Verschiebetisch 22 befestigt sind. Der Excimerlaserstrahl 4 wird mittels einer oder mehrerer optischer Linsen 5 gebündelt und trifft stark abgegrenzt auf den metallorganischen Film 2. Diese dritte Variante des Verfahrens ist insbesondere dann vorteilhaft, wenn die aufzutragende Schicht komplexe Strukturen, wie Linien oder Spiralen aufweisen soll. Mit Hilfe der Linsen können die Strahlen so fokussiert werden, daß sie gerade die Breite dieser Linien bzw. Spiralen aufweisen. Durch Verschiebung der Gesamtanordnung beschichteter Träger 2/Substrat 3/Verschiebetisch 22 in X-oder Y- oder Z- oder X- und Y-und Z-Richtung wird die Substratoberfläche "schreibend" metallisiert. Es ist auch möglich, den gebündelten Excimerlaserstrahl 4 bei feststehender Anordnung beschichteter Träger 2/Substrat 3 in XYZ-Richtung zu verschieben, wichtig ist lediglich, daß sich beim "schreibenden" Verfahren gemäß dritter Variante die Anordnung Substrat/Träger relativ zum Excimerlaserstrahl bewegt.

Als Träger findet bei allen Varianten vorzugsweise ein UV- und lichtdurchlässiger Träger wie Suprasil Quartz (Dicke z.B. 2 mm) oder eine dünne Folie Verwendung.

Als Substrate sind organische oder anorganische Werkstoffe einsetzbar. Die verwendeten Substrate können jede beliebige geometrische Form aufweisen, vorzugsweise werden jedoch dünne Platten verwendet, die aus Al2O3, Aluminiumnitrid, Borsilikat, Glas, Polymid, Gummi, Papier oder Pappe sowie aus keramisch gefüllten oder glasgewebeverstärkten Fluorkunststoffen hergestellt sind.

Auf die gereinigte Oberfläche des Trägers 1 wird zunächst eine pulverförmige metallorganische Verbindung aufgetragen. Die Dicke des aufgetragenen Pulvers wird so gewählt, daß die zu bildende metallische Schicht im fertigen Zustand eine Dicke von vorzugsweise 100 Angström bis 1 $\mu$m aufweist, d.h. die Dicke des Films 2 beträgt vorzugsweise 100 Angström bis 1$\mu$m. Als metallorganische Verbindung können Metallacetate, Metallacetylacetonate und Metallformiate verwendet werden. Soll beispielsweise die zu bildende metallische Schicht aus Palladium bestehen, so wird auf die Oberfläche des Trägers 1 pulverförmiges Palladiumacetat (Dicke z.B. 1000 Angström) aufgetragen. Zur Ausbildung einer aus Kupfer bestehenden metallischen Schicht wird Kupferacetat oder eine andere metallorganische Verbindung aufgetragen, deren metallischer Anteil aus Kupfer besteht. Ein strukturiertes Auftragen des Pulvers ist mittels Siebdruck oder Sprühen möglich.

Alternativ kann der Träger 1 auch mit einen Film aus einem Lösungsmittel überzogen werden, in dem die metallorganische Verbindung gelöst ist. Auf einen Träger 1 kann beispielsweise eine Palladiumacetatlösung durch Tauchen der Substratoberfläche in dieser Lösung Spin-on oder Sprühen aufgebracht werden. Die Schicht kann auch durch Auftragen einer Paladiumchloridlösung gebildet werden. Diese Lösung ist in dieser Form im Handel erhältlich. Nach dem Auftragen muß sie lediglich noch eingetrocknet werden. Ferner besteht die Möglichkeit Cyclopentadienylpalladiumallyl, das in Pulverform vorliegt, in Alkohol oder Wasser zu lösen und auf den Träger 1 aufzutragen. Die Verwendung von pulverförmigem Cyclopentadienylpalladiumchlorid, das zur Ausbildung einer Lösung ebenfalls in Alkohol oder Wasser gelöst wird, ist ebenfalls möglich. Weitere möglichen metallorganischen Verbindungen sind Palladiumacetylacetonat, Cobaltacetat, Nickelacetat, Kupferformiat und Silberneodecanat. Aufgetragene wässrige Lösungen sollten vor der Bestrahlung in einem Ofen eingetrocknet werden. Die Lösungen werden so dick auf das Substrat aufgetragen, daß die metallische Schicht eine Dicke zwischen 5 und 1000 Angström aufweist. Der so beschichtete Träger 1 wird dann ebenso weiterbehandelt, wie der Träger, auf dessen Oberfläche die pulverförmige metallorganische Verbindung aufgetragen ist.

Vorzugsweise sollten beim vorgeschlagenen Verfahren Excimerlaser mit Wellenlängen 190 nm...550 nm und Energiedichten 10 mJ/cm$^2$...1 J/cm$^2$ verwendet werden, da aufgrund der hohen Absorption in UV-Strahlungsbereich und der schnellen Energieeinkopplung (Pulszeit ungefähr 20 ns) die Strukturen scharfkantig übertragen werden können. Weiterhin kann ein YAG-Laser mit der Wellenlänge λ = 532 nm verwendet werden.

Die auf dem Substrat produzierten Metallschichten (Schichtstärke 5... 1000 Angström) aus z.B. Pd, Pt, Cu, Al, Co, Cr, Ni, Ag, Au etc. können als Aktivatoren in stromlosen chemischen Bädern oder unter Einsatz direkter galvanischer Verfahren dienen, d.h. sie werden mit Metallen wie Cu, Ni, Au, Sn, Pd, Pt, Al etc. oder auch binären Verbindungen NiP etc. auf die gewünschte Schichtdicke verstärkt.

**Patentansprüche**

1. Verfahren zur Herstellung von ganzflächigen oder partiellen metallischen Schichten aus einer metallorganischen Verbindung auf einem Substrat durch Bestrahlung mit einer Lichtquelle, dadurch gekennzeichnet, daß ein mit der metallorganischen Verbindung (2) beschichteter UV-oder lichtdurchlässiger Träger (1) mit vorgegebenem Abstand (A) vor dem Substrat (3) angeordnet wird, wobei die metallorganische Verbindung dem Substrat zugewandt ist, und daß anschließend die metallorganische Verbindung der Einwirkung von gepulsten Photonenstrahlen einer definierten Wellenlänge, vorzugsweise der Wellenlänge 190 nm...550 nm, ausgesetzt wird.

2. Verfahren nach Anspruch 1, dadurch gekennzeichnet, daß eine Maske (23) zwischen der Photonen aussendenden Quelle und dem Photonen-durchlässigen Träger (1) angeordnet ist.

3. Verfahren nach Anspruch 1, dadurch gekennzeichnet, daß eine Maske (26) zwischen der metallorganischen Verbindung (2) und dem Substrat (3) angeordnet ist.

4. Verfahren nach Anspruch 1, dadurch gekennzeichnet, daß der Photonen-Strahl mit Hilfe mindestens einer Linse (5) gebündelt wird.

5. Verfahren nach Anspruch 4, dadurch gekennzeichnet, daß die Anordnung beschichteter Träger/Substrat (1/2/3) gegenüber dem Photonen-Strahl in XYZ-Richtung verschiebbar ist.

6. Verfahren nach einem der Ansprüche 1 bis 5, dadurch gekennzeichnet, daß zur Herstellung der metallischen Schichten eine pulverförmige metallorganische Verbindung in vorgegebener Weise mittels Siebdruck oder Sprühen auf die Oberfläche des Trägers (1) aufgetragen wird.

7. Verfahren nach einem der Ansprüche 1 bis 5, dadurch gekennzeichnet, daß zur Herstellung der metallischen Schichten ein Lösungsfilm, der eine metallorganische Verbindung enthält, auf die Oberfläche des Trägers (1) aufgetragen wird, der unter Umständen auch getrocknet wird.

8. Verfahren nach einem der Ansprüche 1 bis 7, dadurch gekennzeichnet, daß zur Herstellung von metallischen Schichten pulverförmige Metallacetate, Metallacetylacetonate oder Metallformiate in einer Dicke zwischen 100 Angström und 1μm auf den Träger (1) aufgetragen werden.

9. Verfahren nach einem der Ansprüche 1 bis 8, dadurch gekennzeichnet, daß zur Herstellung von metallischen Schichten pulverförmige metallorganische Verbindungen oder Lösungen verwendet werden, deren Metallanteil durch Palladium, Kupfer, Platin, Aluminium, Kobalt, Chrom, Nickel, Gold oder Silber gebildet wird.

10. Verfahren nach einem der Ansprüche 1 bis 9, dadurch gekennzeichnet, daß zur Herstellung von metallischen Schichten eine Lösung in Form von Palladiumacetat, Palladiumacetylacetonat, Palladiumchlorid, Kobaltacetat, Nickelacetat, Kupferformiat, Silberneodecanat, Cyclopentadienylpalladiumallyl oder Cyclopentadienylpalladiumchlorid auf den Träger (1) aufgetragen wird.

11. Verfahren nach einem der Ansprüche 1 bis 10, dadurch gekennzeichnet, daß als Träger (1) eine dünne Quarzplatte oder Glasplatte verwendet wird.

12. Verfahren nach einem der Ansprüche 1 bis 10, dadurch gekennzeichnet, daß als Träger (1) eine dünne Folie verwendet wird.

13. Verfahren nach einem der Ansprüche 1 bis 12, dadurch gekennzeichnet, daß Substrate aus organischen oder anorganischen Werkstoffen verwendet werden.

14. Verfahren nach einem der Ansprüche 1 bis 13, dadurch gekennzeichnet, daß zur Herstellung der metallischen Schichten die pulverförmige metallorganische Verbindung oder die aufgetragene Lösung vollständig oder partiell der gepulsten Strahlung eines UV-Hochleistungsstrahlers ausgesetzt wird.

15. Verfahren nach Anspurch 14, dadurch gekennzeichnet, daß zur Herstellung von metallischen Schichten, die pulverförmige metallorganische Verbindung oder die aufgetragene Lösung vollständig oder partiell mit einem Hochleistungsstrahler bestrahlt wird, der Strahlung mit einer Wellenlänge zwischen 60 nm und 550 nm erzeugt.

16. Verfahren nach einem der Ansprüche 1 bis 15, dadurch gekennzeichnet, daß zur Herstellung der metallischen Schichten ein UV-Excimerlaser oder ein Nd YAG-Laser verwendet werden.

17. Verfahren nach einem der Ansprüche 1 bis 16, dadurch gekennzeichnet, daß die metallischen Schichten (8) durch stromlose oder galvanische Metallisierung verstärkt werden.

Fig.1

Fig.2

Fig.3

EP 0 483 782 A2

Fig.4

Fig.5

Fig.6